# FASCICULE DE BREVET EUROPEEN

(11) **EP 2 735 067 B1**
(45) Date de publication et mention de la délivrance du brevet: **09.09.2015**
(21) Numéro de dépôt: 12744042.8
(22) Date de dépôt: 03.07.2012
(51) Int. Cl.: H02J 3/14, H02J 13/00

(54) **MESURE ET MODULATION EN TEMPS REEL DE LA CONSOMMATION ELECTRIQUE D'UNE PLURALITE D'APPAREILS ELECTRIQUES**
MESSUNG UND MODULATION DES STROMVERBRAUCHS EINER VIELZAHL VON ELEKTRISCHEN GERÄTEN IN ECHTZEIT
MEASUREMENT AND MODULATION IN REAL TIME OF THE ELECTRICAL CONSUMPTION OF A PLURALITY OF ELECTRICAL APPLIANCES

(30) Priorité: 19.07.2011 FR 1156528
(43) Date de publication de la demande: 28.05.2014
(73) Titulaire: Voltalis SA, 75008 Paris (FR)
(72) Inventeur: HEINTZ, Bruno, F-75015 Paris (FR); OURY, Jean-Marc, F-75007 Paris (FR); LEFEBVRE DE SAINT GERMAIN, Hugues, F-69110 Sainte-Foy-Lès-Lyon (FR); BIVAS, Pierre, F-78110 Le Vesinet (FR); BINEAU, Mathieu, F-Versailles 78000 (FR)
(74) Mandataire: Hervouet, Sylvie
(86) Numéro de dépôt international: PCT/FR2012/051536
(87) Numéro de publication internationale: WO 2013/011221

(56) Documents cités:
- WO-A1-2011/027195
- US-A1- 2007 220 907
- US-A1- 2010 219 808

## Description

La présente invention est relative à un procédé et un système de mesure et de modulation en temps réel de la consommation électrique d'une pluralité d'appareils électriques prenant en compte les perturbations en fréquence et en tension des lignes électriques du réseau de distribution alimentant ces appareils électriques.

Aujourd'hui, les écarts entre production et consommation électrique entraînent des écarts dans la tension ou la fréquence électrique du réseau de distribution électrique. Ces écarts peuvent occasionner des dégradations des appareils électriques connectés sur le réseau lorsqu'ils sont trop importants (typiquement au-delà de plus ou moins 0,5 Hz autour des 50 Hz en France pour ce qui est de la fréquence, de l'ordre de 10 à 15% pour ce qui est de la tension) et trop fréquents.

On connaît du document US 2010/0219808 un système de mesure de la tension et/ou de la fréquence d'une ligne électrique grâce auquel les écarts de fréquence et/ou de tension peuvent être compensés localement par la coupure ou l'activation d'appareils électriques alimentés par cette ligne électrique. Plus précisément, le système de mesure comporte un dispositif central de contrôle placé dans une habitation et alimenté par une ligne électrique, ce dispositif central de contrôle étant apte à communiquer avec une pluralité de modules de contrôle associés localement à un ou plusieurs appareils électriques sur un réseau local de communication, à mesurer les anomalies en tension et/ou fréquence de la ligne électrique, et à moduler la puissance électrique en agissant localement sur certains appareils électriques, c'est-à-dire en connectant ou en déconnectant selon les cas une partie des appareils électriques.

Néanmoins, le système précédent permet uniquement de traiter localement les anomalies de la ligne électrique, en agissant seulement sur les charges électriques connectées en aval du point de mesure, en l'occurrence, en aval du dispositif central de contrôle.

On connaît par ailleurs un système de mesure et de modulation en temps réel de la consommation électrique d'une pluralité d'appareils électriques, dont le principe est décrit dans le document WO 2008/017754 au nom de la Demanderesse. Ce système de mesure comporte au moins un boîtier modulateur sur lequel peuvent être connectés individuellement ou en série sur des boucles de courant, plusieurs appareils électriques (tels que des chauffe-eau, des radiateurs électriques, des climatiseurs...). Le boîtier modulateur est apte à mesurer en temps réel les tensions et les courants consommés par ces appareils électriques, et à envoyer périodiquement, par exemple toutes les dix minutes, les mesures à une plateforme externe hébergée par un serveur Internet. Cet envoi périodique des mesures s'effectue par l'intermédiaire d'un modem de communication sans fil intégré dans un boîtier pilote du système, le modem de communication sans fil permettant une connexion à la plateforme Internet de type téléphonie par paquet, tel que le GPRS, la 3G ou la 4G. Alternativement, la connexion au réseau Internet peut s'effectuer via une liaison de type ADSL. Le boîtier pilote est préférentiellement distinct du boîtier modulateur et relié à ce dernier par une liaison filaire, de préférence par courant porteur de ligne ou CPL. Pour ce faire, chacun des boîtiers modulateur et pilote est équipé d'un modem CPL. Le boîtier pilote peut ainsi être relié à une pluralité de boîtiers modulateurs dont il collecte les mesures pour envoi à la plateforme externe. Le boîtier pilote comporte avantageusement un port USB qui permet d'accepter le branchement de modules complémentaires tels que des modems radio courte portée ou des capteurs de température. Ainsi, on peut prévoir également que la transmission des mesures depuis les boîtiers modulateurs s'effectue par cette voie radiofréquence. Les mesures reçues par la plateforme externe sont stockées et peuvent être visualisées à tout moment et depuis n'importe quel lieu par l'utilisateur qui peut se connecter sur son espace utilisateur sur Internet par tout moyen connu. La plateforme est en outre susceptible d'envoyer au boîtier pilote, par la connexion sans fil de type téléphonie par paquet, des ordres pour commander l'interruption de l'alimentation de tout ou partie des appareils électriques reliés aux différents boîtiers modulateurs pendant une durée prédéterminée. Les périodes d'interruption sont généralement inférieures à la demi-heure, de sorte que les utilisateurs concernés par les coupures de tout ou partie de leurs appareils électriques, tels que les chauffages ou climatiseurs, ne subissent aucune gêne. Le contrôle de l'alimentation s'effectue par l'intermédiaire des boîtiers modulateurs.

Grâce à ce système, et outre la possibilité de suivi des consommations par chaque utilisateur, on permet de gérer simultanément au niveau de la plateforme centralisée une grande quantité de boîtiers modulateurs et boîtiers pilotes et de moduler plus facilement, à une échelle communale, départementale, régionale ou nationale, la puissance électrique consommée par un ensemble d'utilisateurs, en particulier lors de pics de consommation, sans qu'il soit nécessaire pour les fournisseurs d'énergie électrique de produire plus d'électricité.

Néanmoins, le système décrit dans le document WO 2008/017754 n'offre aucune solution au problème précité des écarts de fréquence et/ou de tension du réseau de distribution électrique.

L'objectif de la présente invention est de proposer une architecture de système du type de celle décrite dans le document WO 2008/017754 qui permette d'offrir une réponse adaptée aux perturbations en fréquence et/ou en tension susceptibles d'être présentes sur le réseau de distribution électrique. Plus précisément, l'invention cherche un système de mesure et de modulation en temps réel apte à corriger les écarts de puissance et de fréquence électriques en bout de ligne.

Ainsi, la présente invention a pour objet un procédé de mesure et de modulation en temps réel de la consommation électrique d'une pluralité d'appareils électriques alimentés à partir d'au moins une ligne électrique d'un réseau de distribution électrique fournissant un signal d'alimentation à une tension nominale et à une fréquence nominale, caractérisé en ce qu'il comporte les étapes suivantes :
- Mesure en temps réel du courant consommé par chacun des appareils électriques sur chaque portion de ligne électrique sur laquelle se situe chaque appareil électrique;
- Extraction de la fréquence et de la tension du signal électrique sur chaque portion de ligne électrique sur laquelle se situe chaque appareil électrique;
- Calcul de l'écart en fréquence, en valeur absolue, entre la fréquence extraite et la fréquence nominale du réseau de distribution et/ou de l'écart en tension, en valeur absolue, entre la tension extraite et la tension nominale du réseau de distribution électrique pour chaque portion de ligne électrique;
- Génération d'un signal d'alerte associé à une portion de ligne électrique dès lors que l'écart en fréquence sur cette portion de ligne électrique est supérieur à une valeur seuil en fréquence prédéterminée et/ou que l'écart en tension sur cette portion de ligne électrique est supérieur à une valeur seuil en tension prédéterminée;
- Transmission de la consommation électrique de chacun des appareils électriques et du signal d'alerte à une plateforme centrale externe;
- Envoi par ladite plateforme centrale externe d'ordres de coupure sélectifs de certains appareils électriques, quelle que soit la position de ces appareils électriques par rapport à la portion de ligne électrique pour laquelle le signal d'alerte a été généré.

Ainsi, la plateforme centrale peut commander des mesures correctives en tenant compte des écarts de fréquence et/ou de tension, lesquelles mesures correctives pourront être réalisées indifféremment sur des appareils électriques situés en aval ou en amont de la portion de ligne électrique pour laquelle le signal d'alerte a été généré.

La présente invention a également pour objet un système de mesure et de modulation en temps réel de la consommation électrique d'une pluralité d'appareils électriques alimentés à partir d'au moins une ligne électrique d'un réseau de distribution électrique fournissant un signal d'alimentation à une tension nominale et à une fréquence nominale, le système comprenant une pluralité de boîtiers modulateurs comportant des moyens de mesure en temps réel du courant consommé par chacun des appareils électriques sur chaque portion de ligne électrique sur laquelle se situe chaque appareil électrique, une pluralité de boîtiers pilotes aptes à échanger localement des données avec un ou plusieurs desdits boîtiers modulateurs, et une plateforme centrale externe hébergée par un serveur Internet, apte à échanger des données avec lesdits boîtiers pilotes , le système étant caractérisé en ce que :
- lesdits boîtiers modulateurs comportent des moyens d'extraction de la fréquence et de la tension du signal électrique sur chaque portion de ligne électrique sur laquelle se situe chaque appareil électrique;
- lesdits boîtiers modulateurs ou lesdits boîtiers pilotes comportent des moyens de calcul de l'écart en fréquence, en valeur absolue, entre la fréquence extraite et la fréquence nominale du réseau de distribution et/ou de l'écart en tension, en valeur absolue, entre la tension extraite et la tension nominale du réseau de distribution électrique pour chaque portion de ligne électrique et des moyens de génération d'un signal d'alerte associé à une portion de ligne électrique dès lors que l'écart en fréquence sur cette portion de ligne électrique est supérieur à une valeur seuil en fréquence prédéterminée et/ou que l'écart en tension sur cette portion de ligne électrique est supérieur à une valeur seuil en tension prédéterminée;
en ce que les boîtiers pilotes sont aptes à transmettre la consommation électrique de chacun des appareils électriques et le signal d'alerte à la plateforme centrale externe et en ce que ladite plateforme centrale externe est apte à envoyer des ordres de coupure sélectifs de certains appareils électriques, quelle que soit la position de ces appareils électriques par rapport à la portion de ligne électrique pour laquelle le signal d'alerte a été généré.

Selon d'autres caractéristiques préférentielles de l'invention:
- la plateforme centrale externe est apte à échanger des données avec lesdits boîtiers pilotes par l'intermédiaire d'une liaison de communication de type filaire, notamment une liaison ADSL, ou une liaison de communication sans fil de type GPRS, 3G ou 4G.
- les boîtiers pilotes sont aptes à échanger localement des données avec un ou plusieurs desdits boîtiers modulateurs via une liaison de communication filaire de type courant porteur de ligne, ou une liaison de communication radiofréquence à courte portée.
- Alternativement, chaque boîtier pilote est intégré dans un boîtier modulateur.

Différents aspects de l'invention apparaîtront dans la description suivante, faite en référence aux figures annexées, dans lesquelles :
- la figure 1 représente schématiquement une portion d'un système de mesure et de modulation en temps réel de la consommation électrique d'une pluralité d'appareils électriques conforme à l'invention;
- la figure 2 illustre schématiquement un boîtier modulateur conforme à l'invention;
- la figure 3 représente différentes étapes mises en oeuvre dans le procédé selon l'invention.

Dans la suite de l'exposé, les éléments communs aux différentes figures portent les mêmes références.

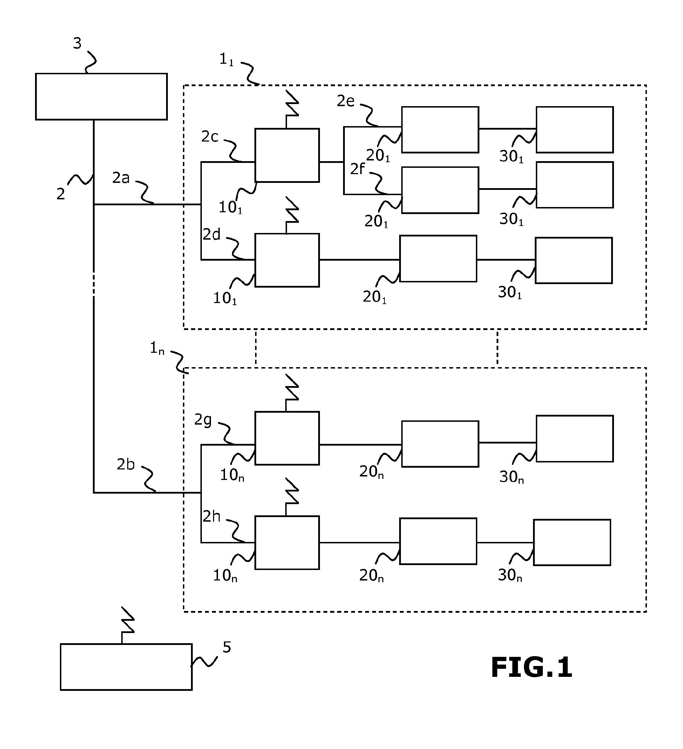

La figure 1 illustre l'architecture d'une portion d'un système de mesure et de modulation en temps réel d'une pluralité d'appareils électriques. La portion du système représenté permet, dans l'exemple illustré, la gestion d'une pluralité d'appareils électriques équipant n bâtiments 1₁ à 1ₙ, tous alimentés à partir d'une même ligne électrique 2 en sortie d'un transformateur électrique 3 du réseau de distribution électrique. Dans cet exemple, le bâtiment 1₁ est celui qui est le plus près du transformateur, alors que le bâtiment 1ₙ se retrouve en bout de ligne. Dans chaque bâtiment sont installés au moins un boîtier modulateur et un boîtier pilote. Plus précisément, le bâtiment 1₁ comporte deux boîtiers pilotes 10₁ et trois boîtiers modulateurs 20₁, chacun étant relié à un appareil électrique 30₁. L'un des boîtiers pilotes 10₁ est relié à deux boîtiers modulateurs 20₁, alors que l'autre n'est relié qu'à un seul boîtier modulateur 20₁. Cette configuration peut par exemple correspondre à une installation dans deux appartements d'un même immeuble, ou bien à deux étages d'une maison. Le bâtiment 1ₙ comporte quant à lui deux boîtiers pilotes 10ₙ, chacun relié à un boîtier modulateur 20ₙ, lui-même relié à un appareil électrique 30ₙ. D'autres configurations dans chaque bâtiment peuvent être envisagées, sans départir du cadre de l'invention. Les références 2a et 2b représentent les portions de lignes électriques dérivées de la ligne électrique 2, et alimentant respectivement les bâtiments 1₁ et 1ₙ. Dans la configuration illustrée, la portion de ligne 2a se sépare en deux tronçons 2c et 2d pour liaison respective à chacun des deux boîtiers pilotes 10₁ du bâtiment 1₁. La portion de ligne correspondant au tronçon 2c se sépare également en deux tronçons 2e et 2f. Enfin, la portion de ligne 2b relative au bâtiment 1ₙ se sépare en deux tronçons 2g et 2h pour liaison respective à chacun des deux boîtiers pilotes 10ₙ du bâtiment 1ₙ.

Chaque boîtier modulateur 20₁ et 20ₙ peut échanger des données avec une plateforme centrale externe 5 hébergée par un serveur Internet par l'intermédiaire des boîtiers pilotes 10₁ et 10ₙ par une liaison Internet filaire, notamment une liaison ADSL, ou par une liaison de communication sans fil de type GPRS, 3G ou 4G.

Par ailleurs les boîtiers pilotes 10₁, 10ₙ sont aptes à échanger localement des données avec lesdits boîtiers modulateurs 20₁, 20ₙ auxquels ils sont reliés via une liaison de communication filaire de type courant porteur de ligne, ou une liaison de communication radiofréquence à courte portée.

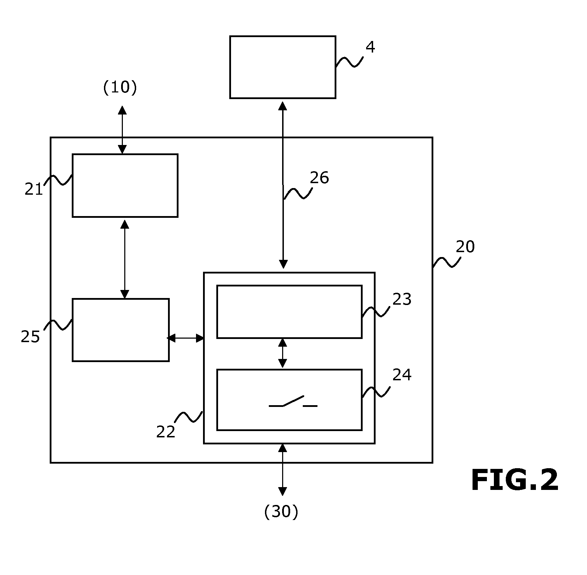

La figure 2 illustre schématiquement les composantes d'un boîtier modulateur 20 selon un mode préféré de l'invention. On rappelle qu'un boîtier modulateur 20 est apte à être relié à un unique boîtier pilote 10, mais peut être relié à une pluralité d'appareils électriques, typiquement jusqu'à quatre. Dans l'exemple représenté sur la figure 2, on a supposé néanmoins, pour ne pas surcharger la figure, que le boîtier modulateur 20 n'était connecté qu'à une seul appareil électrique 30. Le boîtier modulateur 20 comporte typiquement :
- un module 21 de communication pour la gestion des communications bidirectionnelles avec le boîtier pilote 10 auquel il est connecté, typiquement un modem courant porteur de ligne;
- un module 22 de contrôle électrique comportant un dispositif de mesure 23 du courant, par exemple une boucle à induction, et un relais électrique 24 par l'intermédiaire duquel sont répercutés d'éventuels ordres de coupure d'alimentation à l'appareil électrique 30;
- un module 25 de traitement des données, en particulier de recueil des mesures en sortie du dispositif de mesure 23, d'extraction des paramètres de mesure, notamment la tension et la fréquence de la portion de ligne sur lequel de boîtier modulateur se situe, et de conservation des données de mesure et d'interruptions électriques. Ce module 25 est également apte à recevoir, via le boîtier pilote 10 auquel il est relié et son module 21 de communication, des instructions de la plateforme centrale 5 le conduisant à transmettre les données, actualiser les paramètres d'acquisition et de traitement des données sur la base desquels il opère, et déclencher le relais électrique 24.
- une liaison électrique filaire 26 pour relier le boîtier modulateur 20 au tableau électrique 4.

La structure représentée schématiquement sur la figure 2 s'applique à tous les boîtiers modulateurs 20₁ et 20ₙ compris dans le système représenté à titre d'exemple sur la figure 1.

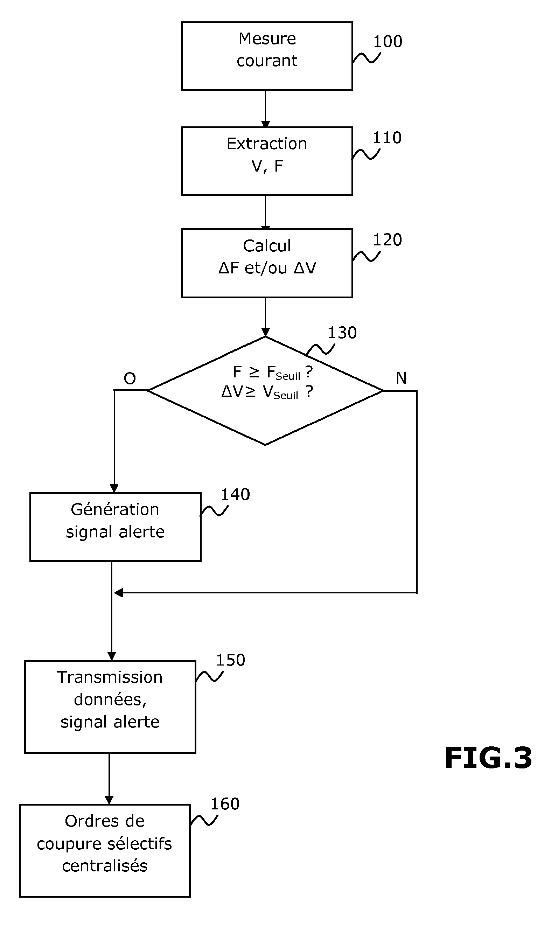

Le fonctionnement de la portion de système illustré sur les figures 1 et 2 va à présent être explicité en référence à la figure 3. Chaque boîtier modulateur 20₁ et 20ₙ mesure en temps réel les courants consommés par les appareils électriques 30₁ et 30ₙ (étape 100) grâce à son dispositif de mesure 23.

Le module 25 de traitement de données extrait alors la tension et la fréquence du signal sur la portion de ligne électrique où se situe le boîtier de mesure (étape 110). A partir de la tension et du courant, chaque boîtier modulateur peut calculer en temps réel la puissance consommée par chaque appareil électrique auquel il est relié.

L'extraction de la fréquence peut être réalisée selon différentes méthodes. En particulier, le signal électrique prélevé par le dispositif de mesure 23 est classiquement amplifié si nécessaire, puis transformé en signal carré via un trigger de Schmitt (non représenté). La fréquence du signal est estimée en comptant le nombre de transitions du signal carré de 0 à 1 sur une durée dépendante de la précision recherchée, par exemple sur 10 secondes.

Le module 25 de traitement des données procède alors, lors d'une étape 120, au calcul de l'écart en valeur absolue entre la fréquence extraite et la fréquence nominale du réseau de distribution (ci-après écart en fréquence Δf), et/ou au calcul de l'écart, en valeur absolue, entre la tension extraite et la tension nominale du réseau de distribution électrique (ci-après écart en tension ΔV). L'écart en fréquence et/ou l'écart en tension sont ensuite comparés à des valeurs seuil Vₛₑᵤᵢₗ et fₛₑᵤᵢₗ prédéterminées et stockées dans le module 25 de traitement des données (étape 130). A titre d'exemple, pour le réseau de distribution électrique français (tension nominale de 220 Volts à la fréquence nominale de 50 Hertz), la valeur seuil Vₛₑᵤᵢₗ est de l'ordre de 10 à 15% de 220 Volts, et la valeur seuil fₛₑᵤᵢₗ est de 0,5 Hertz. Le module 25 de traitement des données génère un signal d'alerte dès lors que l'un des écarts est supérieur à la valeur seuil de référence Vₛₑᵤᵢₗ ou fₛₑᵤᵢₗ (étape 140). Les différentes mesures de puissances consommées, ainsi que les signaux d'alerte le cas échéant, sont transmis à la plateforme centrale 5 (étape 150).

La plateforme centrale 5 peut ensuite agir au niveau local, sur certains appareils, pour moduler la puissance électrique consommée chez un ensemble d'utilisateurs, et ajuster ainsi localement en temps réel la consommation électrique par rapport à la production, en tenant compte des écarts de fréquence et/ou de tension. Plus précisément, la plateforme centrale externe 5 va pouvoir transmettre, lors d'une étape 160, des ordres de coupure sélectifs de certains appareils électriques, et ce, quelle que soit la position de ces appareils électriques par rapport à la portion de ligne électrique pour laquelle le signal d'alerte a été généré. En d'autres termes, les mesures correctives pourront être réalisées indifféremment sur des appareils électriques situés en aval ou en amont de la portion de ligne électrique pour laquelle le signal d'alerte a été généré.

Grâce au système selon l'invention, la mesure et la modulation sont effectuées au niveau de chaque appareil ou groupe d'appareils électriques, contrairement à la solution proposée dans le document US 2010/0219808 dans laquelle la mesure s'effectue au niveau d'un bâtiment. Un premier intérêt de l'invention est donc de permettre un diagnostic local d'un problème qui peut être local, par exemple si la mesure effectuée sur le boîtier modulateur 20ₙ situé sur la portion de ligne 2g du bâtiment 1ₙ est anormale alors qu'elle est normale pour le boîtier modulateur 20ₙ situé sur la portion de ligne 2h du même bâtiment, et de fournir à l'opérateur une cartographie très précise de l'endroit où apparaissent les problèmes.

La solution proposée par l'invention est en outre particulièrement adaptée aux problématiques de bouts de lignes électriques, qui voient le signal électrique se dégrader progressivement lorsque l'on s'éloigne du transformateur 3. Supposons en effet qu'un écart de fréquence important apparaisse dans le tronçon de ligne électrique 2g du bâtiment 1ₙ. Dans la solution proposée par le document US 2010/0219808, la détection de cet écart sera faite au niveau de la portion de ligne 2b du bâtiment 1ₙ, et les actions correctives ne pourront être prises que localement sur les appareils électriques 30ₙ installés dans le bâtiment 1ₙ en aval de cette portion de ligne 2b. Or, ces actions correctives peuvent s'avérer insuffisantes ou inappropriées. En particulier, la qualité du signal électrique se dégradant au fur et à mesure de la ligne d'alimentation, il est possible que le signal soit parfaitement dans les limites au niveau de l'alimentation 2a du bâtiment 1₁, mais ne le soit plus au niveau de l'alimentation 2b, entre autre à cause de l'utilisation des appareils 30₁ dans le bâtiment 1₁. Grâce à l'invention, il est possible de corriger une dégradation du signal en agissant également en amont du point de mesure où l'anomalie a été détectée, à un endroit où la qualité du signal est correcte, typiquement, dans notre exemple, au niveau des appareils électriques 30₁ du bâtiment 1₁.

Dans l'implémentation de l'invention telle que décrite précédemment, les mesures d'écarts et la génération d'alerte sont réalisées au niveau de chaque boîtier modulateur 20₁, 20ₙ. En variante néanmoins, dans le cas où les boîtiers pilotes sont distincts des boîtiers modulateurs, on peut également envisager que la mesure des écarts soit transmise par les boîtiers modulateurs 20₁, 20ₙ aux boîtiers pilotes 10₁, 10ₙ auxquels ils sont reliés, et que la génération des signaux d'alerte suite aux comparaisons avec les valeurs seuils soit réalisée par les boîtiers pilotes 10₁, 10ₙ.

## Revendications

1. Procédé de mesure et de modulation en temps réel de la consommation électrique d'une pluralité d'appareils électriques (30₁, 30ₙ) alimentés à partir d'au moins une ligne électrique (2) d'un réseau de distribution électrique fournissant un signal d'alimentation à une tension nominale et à une fréquence nominale, **caractérisé en ce qu'**il comporte les étapes suivantes :
- Mesure (100) en temps réel du courant consommé par chacun des appareils électriques (30₁, 30ₙ) sur chaque portion de ligne électrique sur laquelle se situe chaque appareil électrique (30₁, 30ₙ) ;
- Extraction (110) de la fréquence et de la tension du signal électrique sur chaque portion de ligne électrique sur laquelle se situe chaque appareil électrique (30₁, 30ₙ) ;
- Calcul (120) de l'écart en fréquence, en valeur absolue, entre la fréquence extraite et la fréquence nominale du réseau de distribution et/ou de l'écart en tension, en valeur absolue, entre la tension extraite et la tension nominale du réseau de distribution électrique pour chaque portion de ligne électrique;
- Génération (130, 140) d'un signal d'alerte associé à une portion de ligne électrique dès lors que l'écart en fréquence sur cette portion de ligne électrique est supérieur à une valeur seuil en fréquence prédéterminée (fₛₑᵤᵢₗ) et/ou que l'écart en tension sur cette portion de ligne électrique est supérieur à une valeur seuil en tension prédéterminée (Vₛₑᵤᵢₗ) ;
- Transmission (150) de la puissance électrique consommée par chacun des appareils électriques et du signal d'alerte à une plateforme centrale externe (5) ;
- Envoi (160) par ladite plateforme centrale externe (5) d'ordres de coupure sélectifs de certains appareils électriques, quelle que soit la position de ces appareils électriques par rapport à la portion de ligne électrique pour laquelle le signal d'alerte a été généré, afin d'ajuster localement en temps réel la consommation électrique par rapport à la production.

2. Système de mesure et de modulation en temps réel de la consommation électrique d'une pluralité d'appareils électriques (30₁, 30ₙ ; 30) alimentés à partir d'au moins une ligne électrique (2) d'un réseau de distribution électrique fournissant un signal d'alimentation à une tension nominale et à une fréquence nominale, le système comprenant une pluralité de boîtiers modulateurs (20₁, 20ₙ ; 20) comportant des moyens (23) de mesure en temps réel du courant consommé par chacun des appareils électriques (30₁, 30ₙ ; 30) sur chaque portion de ligne électrique sur laquelle se situe chaque appareil électrique (30₁, 30ₙ ; 30), une pluralité de boîtiers pilotes (10₁, 10ₙ ; 10) aptes à échanger localement des données avec un ou plusieurs desdits boîtiers modulateurs (20₁, 20ₙ ; 20), et une plateforme centrale externe (5) hébergée par un serveur Internet, apte à échanger des données avec lesdits boîtiers pilotes (10₁, 10ₙ ; 10), le système étant **caractérisé en ce que** :
- lesdits boîtiers modulateurs (20₁, 20ₙ ; 20) comportent des moyens (25) d'extraction de la fréquence et de la tension du signal électrique sur chaque portion de ligne électrique sur laquelle se situe chaque appareil électrique (30₁, 30ₙ ; 30);
- lesdits boîtiers modulateurs (20₁, 20ₙ ; 20) ou lesdits boîtiers pilotes (10₁, 10ₙ ; 10) comportent des moyens (25) de calcul de l'écart en fréquence, en valeur absolue, entre la fréquence extraite et la fréquence nominale du réseau de distribution et/ou de l'écart en tension, en valeur absolue, entre la tension extraite et la tension nominale du réseau de distribution électrique pour chaque portion de ligne électrique et des moyens (25) de génération d'un signal d'alerte associé à une portion de ligne électrique dès lors que l'écart en fréquence sur cette portion de ligne électrique est supérieur à une valeur seuil en fréquence prédéterminée (fₛₑᵤᵢₗ) et/ou que l'écart en tension sur cette portion de ligne électrique est supérieur à une valeur seuil en tension prédéterminée (Vₛₑᵤᵢₗ);
**en ce que** les boîtiers pilotes (10₁, 10ₙ ; 10) sont aptes à transmettre la puissance électrique consommée par chacun des appareils électriques (30₁, 30ₙ ; 30) et le signal d'alerte à la plateforme centrale externe (5) et **en ce que** ladite plateforme centrale externe (5) est apte à envoyer des ordres de coupure sélectifs de certains appareils électriques, quelle que soit la position de ces appareils électriques par rapport à la portion de ligne électrique pour laquelle le signal d'alerte a été généré, afin d'ajuster localement en temps réel la consommation électrique par rapport à la production.

3. Système selon la revendication 2, **caractérisé en ce que** la plateforme centrale externe (5) est apte à échanger des données avec lesdits boîtiers pilotes (10₁, 10ₙ) par l'intermédiaire d'une liaison de communication de type filaire, notamment une liaison ADSL, ou une liaison de communication sans fil de type GPRS, 3G ou 4G.

4. Système selon l'une quelconque des revendications 2 ou 3, **caractérisé en ce que** lesdits boîtiers pilotes (10₁, 10ₙ) sont aptes à échanger localement des données avec un ou plusieurs desdits boîtiers modulateurs (20₁, 20ₙ) via une liaison de communication filaire de type courant porteur de ligne, ou une liaison de communication radiofréquence à courte portée.

5. Système selon la revendication l'une quelconque des revendications 2 ou 3, **caractérisé en ce que** chaque boîtier pilote (10₁, 10ₙ) est intégré dans un boîtier modulateur (20₁, 20ₙ).

## Patentansprüche

1. Verfahren zum Messen und Modulieren in Echtzeit des Stromverbrauchs einer Vielzahl von elektrischen Geräten (30₁, 30ₙ), die von mindestens einer Stromleitung (2) eines Stromverteilungsnetzes versorgt werden, das ein Versorgungssignal auf einer Nennspannung und einer Nennfrequenz bereitstellt, **dadurch gekennzeichnet, dass** es folgende Schritte umfasst:
- Messen in Echtzeit (100) des Stroms, der von jedem der elektrischen Geräte (30₁, 30ₙ) auf jedem Stromleitungsabschnitt verbraucht wird, auf dem sich jedes elektrische Gerät (30₁, 30ₙ) befindet) ;
- Entnehmen (110) der Frequenz und der Spannung des elektrischen Signals auf jedem Stromleitungsabschnitt, auf dem sich jedes elektrische Gerät (30₁, 30ₙ) befindet;
- Berechnen (120) der Frequenzabweichung in absoluten Werten zwischen der entnommenen Frequenz und der Nennfrequenz des Verteilungsnetzes und/oder der Spannungsabweichung in absoluten Werten zwischen der entnommenen Spannung und der Nennspannung des Stromverteilungsnetzes für jeden Stromleitungsabschnitt;
- Generieren (130, 140) eines Alarmsignals, das mit einem Stromleitungsabschnitt verknüpft ist, sofern die Frequenzabweichung auf diesem Stromleitungsabschnitt größer als ein vorbestimmter Frequenzschwellenwert (fₛₑᵤᵢₗ) ist und/oder die Spannungsabweichung auf diesem Stromleitungsabschnitt größer als ein vorbestimmter Spannungsschwellenwert (Vₛₑᵤᵢₗ) ist;
- Übertragen (150) der elektrischen Energie, die von jedem der elektrischen Geräte verbraucht wird, und des Alarmsignals an eine externe zentrale Plattform (5);
- Senden (160) durch die externe zentrale Plattform (5) von Befehlen zum selektiven Abschalten bestimmter elektrischer Geräte, unabhängig von der Position der elektrischen Geräte im Verhältnis zu dem Stromleitungsabschnitt, für den das Alarmsignal generiert wurde, um den Stromverbrauch im Verhältnis zur Produktion in Echtzeit lokal anzupassen.

2. System zum Messen und Modulieren in Echtzeit des Stromverbrauchs einer Vielzahl von elektrischen Geräten (30₁, 30ₙ), die von mindestens einer Stromleitung (2) eines Stromverteilungsnetzes versorgt werden, das ein Versorgungssignal auf einer Nennspannung und einer Nennfrequenz abgibt, wobei das System eine Vielzahl von Modulatorkästen (20₁, 20ₙ; 20), die Mittel (23) zum Messen in Echtzeit des Stroms umfassen, der von jedem der elektrischen Geräte (30₁, 30ₙ; 30) auf jedem Stromleitungsabschnitt verbraucht wird, auf dem sich jedes elektrische Gerät (30₁, 30ₙ; 30) befindet, eine Vielzahl von Pilotkästen (10₁, 10ₙ; 10), die geeignet sind zum lokalen Austauschen von Daten mit einem oder mehreren der Modulatorkästen (20₁, 20ₙ; 20), und eine externe zentrale Plattform (5), die von einem Internet-Server gehostet wird und geeignet ist zum Austauschen von Daten mit den Pilotkästen (10₁, 10ₙ; 10), umfasst, wobei das System **dadurch gekennzeichnet ist, dass**:
- die Modulatorkästen (20₁, 20ₙ; 20) Mittel (25) zum Entnehmen der Frequenz und der Spannung des elektrischen Signals auf jedem Stromleitungsabschnitt, auf dem sich jedes elektrische Gerät (30₁, 30ₙ; 30) befindet, umfassen;
- wobei die Modulatorkästen (20₁, 20ₙ; 20) oder die Pilotkästen (10₁, 10ₙ; 10) Mittel (25) zum Berechnen der Frequenzabweichung in absoluten Werten zwischen der entnommenen Frequenz und der Nennfrequenz des Verteilungsnetzes und/oder der Spannungsabweichung in absoluten Werten zwischen der entnommenen Spannung und der Nennspannung des Stromverteilungsnetzes für jeden Stromleitungsabschnitt, und Mittel (25) zum Generieren eines Alarmsignals, das mit einem Stromleitungsabschnitt verknüpft ist, sofern die Frequenzabweichung auf diesem Stromleitungsabschnitt größer als ein vorbestimmter Frequenzschwellenwert (fₛₑᵤᵢₗ) ist und/oder die Spannungsabweichung auf diesem Stromleitungsabschnitt größer als ein vorbestimmter Spannungsschwellenwert (Vₛₑᵤᵢₗ) ist, umfassen;
dass die Pilotkästen (10₁, 10ₙ; 10) geeignet sind, um die elektrische Energie, die von jedem der elektrischen Geräte (30₁, 30ₙ; 30) verbraucht wird, und das Alarmsignal an eine externe zentrale Plattform (5) zu übertragen, und dass die externe zentrale Plattform (5) geeignet ist, um Befehle zum selektiven Abschalten bestimmter elektrischer Geräte, unabhängig von der Position der elektrischen Geräte im Verhältnis zu dem Stromleitungsabschnitt, für den das Alarmsignal generiert wurde, um den Stromverbrauch im Verhältnis zur Produktion in Echtzeit lokal anzupassen, geeignet ist.

3. System nach Anspruch 2, **dadurch gekennzeichnet, dass** die externe zentrale Plattform (5) geeignet ist, um mit den Pilotkästen (10₁, 10ₙ) über eine drahtgebundene Kommunikationsverbindung, nämlich eine DSL-Verbindung, oder eine drahtlose Kommunikationsverbindung nach Art von GPRS, 3G oder 4G Daten auszutauschen.

4. System nach einem der Ansprüche 2 oder 3, **dadurch gekennzeichnet, dass** die Pilotkästen (10₁, 10ₙ) geeignet sind, um mit einem oder mehreren der Modulatorkästen (20₁, 20ₙ) über eine drahtgebundene Kommunikationsverbindung nach Art eines Leitungsträgerstroms oder einer Kurzstreckenfunk-Kommunikationsverbindung lokal Daten auszutauschen.

5. System nach einem der Ansprüche 2 oder 3, **dadurch gekennzeichnet, dass** jeder Pilotkasten (10₁, 10ₙ) in einen Modulatorkasten (20₁, 20ₙ) eingebaut ist.

## Claims

1. A method for real-time measuring and modulating power consumption of a plurality of electrical appliances (30₁, 30ₙ) supplied from at least one power line (2) of a power distribution network providing a supply signal at a nominal voltage and a nominal frequency, **characterized in that** it comprises the following steps:
- real-time measuring (100) of current drawn by each of the electrical appliances (30₁, 30ₙ) on each power line portion where each electrical appliance (30₁, 30ₙ) is located;
- extracting (110) the frequency and voltage of the electrical signal on each power line portion where each electrical appliance (30₁, 30ₙ) is located;
- calculating (120) the frequency offset in terms of absolute value between the extracted frequency and the nominal frequency of the distribution network and/or the voltage offset in terms of absolute value between the extracted voltage and the nominal voltage of the power distribution network for each power line portion;
- generating (130, 140) an alarm signal associated with a power line portion provided that the frequency offset on this power line portion is greater than a predetermined frequency threshold value (fₛₑᵤᵢₗ) and/or the voltage offset on this power line portion is greater than a predetermined voltage threshold value (Vₛₑᵤᵢₗ);
- transmitting (150) the electrical power drawn by each of the electrical appliances and the alarm signal to an external central platform (5);
- sending (160) by the external central platform (5) selective shut-down orders to some of the electrical appliances, regardless of the position of said electrical appliances with respect to the power line portion for which the alarm signal has been generated, in order to locally adjust power consumption in real time with respect to production.

2. A system for real-time measuring and modulating power consumption of a plurality of electrical appliances (30₁, 30ₙ) supplied from at least one power line (2) of a power distribution network providing a supply signal at a nominal voltage and a nominal frequency, the system comprising a plurality of modulator boxes (20₁, 20ₙ; 20) including means (23) for real-time measuring of the current drawn by each of the electrical appliances (30₁, 30ₙ; 30) on each power line portion where each electrical appliance (30₁, 30ₙ; 30) is located, a plurality of pilot boxes (10₁, 10ₙ; 10) adapted for locally exchanging data with one or more of said modulator boxes (20₁, 20ₙ; 20), and an external central platform (5) hosted by an internet server, adapted for exchanging data with said pilot boxes (10₁, 10ₙ; 10), the system being **characterized in that**:
- said modulator boxes (20₁, 20ₙ; 20) include means (25) for extracting the frequency and the voltage of the electrical signal on each power line portion where each electrical appliance (30₁, 30ₙ; 30) is located;
- said modulator boxes (20₁, 20ₙ; 20) or said pilot boxes (10₁, 10ₙ; 10) including means (25) for calculating the frequency offset in terms of absolute value between the extracted frequency and the nominal frequency of the distribution network and/or the voltage offset in terms of absolute value between the extracted voltage and the nominal voltage of the power distribution network for each power line portion, and means (25) for generating an alarm signal associated with a power line portion provided that the frequency offset on this power line portion is greater than a predetermined frequency threshold value (fₛₑᵤᵢₗ) and/or the voltage offset on this power line portion is greater than a predetermined voltage threshold value (Vₛₑᵤᵢₗ);
**in that** the pilot boxes (10₁, 10ₙ; 10) are adapted for transmitting the electrical power drawn by each of the electrical appliances (30₁, 30ₙ; 30) and the alarm signal to the external central platform (5), and **in that** said external central platform (5) is adapted for sending selective shut-down orders to some of the electrical appliances, regardless of the position of said electrical appliances with respect to the power line portion for which the alarm signal has been generated, in order to locally adjust power consumption in real time with respect to production.

3. The system according to claim 2, **characterized in that** the external central platform (5) is adapted for exchanging data with said pilot boxes (10₁, 10ₙ) via a wired communication link, namely an ADSL link, or a wireless communication link of the GPRS, 3G, or 4G type.

4. The system according to any of claims 2 or 3, **characterized in that** said pilot boxes (10₁, 10ₙ) are adapted for locally exchanging data with one or more of said modulator boxes (20₁, 20ₙ) via a wired communication link of the line carrier type or a short-range radiofrequency communication link.

5. The system according to any of claims 2 or 3, **characterized in that** each pilot box (10₁, 10ₙ) is integrated into a modulator box (20₁, 20ₙ) .
